# DEMANDE DE BREVET EUROPEEN

(11) **EP 4 459 661 A1**
(43) Date de publication de la demande: **06.11.2024**
(21) Numéro de dépôt: 24173158.7
(22) Date de dépôt: 29.04.2024
(51) Int. Cl.: H01L 21/02, H01L 21/32

(54) **STRUCTURATION D'UNE COUCHE FONCTIONNELLE AU MOYEN D'UNE COUCHE SACRIFICIELLE ET PRÉPARATION D'UNE CAPACITANCE DE TYPE MIM METTANT EN UVRE LADITE STRUCTURATION**

(30) Priorité: 02.05.2023 FR 2304397
(71) Demandeur: Commissariat à l'Energie Atomique et aux Energies Alternatives, 75015 Paris (FR)
(72) Inventeur: BEDJAOUI, Messaoud, 38054 GRENOBLE (FR)
(74) Mandataire: Brevalex

(57) **Abrégé**

L'invention se rapporte, dans un premier temps, à un procédé de structuration d'une couche fonctionnelle (130), comprenant au moins les étapes suivantes :
a) fourniture d'un substrat (110) ayant une surface recouverte localement par une couche dite sacrificielle (120), une ou plusieurs zones de la surface du substrat (110) étant dépourvue de la couche sacrificielle (120) ;
b) croissance de la couche fonctionnelle (130) de manière sélective sur la ou les zones de la surface du substrat (110) dépourvues de la couche sacrificielle (120) ;
c) élimination de la couche sacrificielle (120) ;
moyennant quoi la surface du substrat (110) est recouverte par une couche fonctionnelle (130) structurée.

L'invention se rapporte ensuite à un procédé de préparation d'une capacitance de type MIM, en mettant en oeuvre le procédé de structuration pour structurer au moins une couche de la capacitance.

Applications : dispositifs micro- et nano-électroniques tels que des puces électroniques, fabrication de capacitances hautes densités de type MIM.

## Description

### DOMAINE TECHNIQUE

L'invention se rapporte au domaine des micro- et nano-technologies et plus spécifiquement au domaine de la production de dispositifs micro- et nano-électroniques.

Plus particulièrement, l'invention se rapporte, en premier lieu, à un procédé permettant de structurer une couche fonctionnelle au moyen d'une couche dite sacrificielle.

L'invention a-t-elle aussi pour objet un procédé de préparation de capacitance de type MIM (pour « *Métal-Isolant-Métal* ») en mettant en oeuvre un procédé permettant de structurer une couche fonctionnelle de la capacitance au moyen d'une couche sacrificielle.

L'invention trouve notamment application dans la micro- et nano-technologie et plus spécifiquement dans la fabrication de capacitances hautes densités telles que des capacitances de type MIM, par exemple pour des puces électroniques.

### ÉTAT DE LA TECHNIQUE ANTÉRIEURE

L'avènement des objets connectés et intelligents fait actuellement l'objet de recherches et notamment des recherches sur des dispositifs micro- et nano-électroniques très avancés et de plus en plus complexes.

Outre les développements liés à l'architecture et au motif (« *design* ») des composants micro- et nano-électroniques permettant de répondre à des critères technologiques et à de performances très avancées, la structuration de la matière à des tailles submicroniques et nanométriques est l'un des points clefs dans la fabrication de telles technologies.

Les capacitances de type MIM - correspondant à un empilement d'une couche diélectrique imbriquée entre deux électrodes - représentent l'un des composants essentiels de ces dispositifs micro- et nano-électroniques.

Pour structurer ou délimiter le dépôt de couches de matériaux lors de la fabrication de tels composants, des procédés de photolithographie et de gravure sont généralement mis en oeuvre.

Cependant, avec la course à la miniaturisation des dispositifs micro- et nano-électroniques, nous assistons à une multiplication du nombre d'étapes dans les procédés de photolithographie et de gravure ainsi qu'une complexification de ces étapes, par exemple en mettant en oeuvre un procédé de photolithographie à multiple expositions (ou LELE pour « *Litho Etch Litho Etch* » en anglais) ou encore un procédé de multi-structurations auto-alignés (ou SADP pour « *Self-Aligned Double Patterning* » en anglais).

Or, la multiplication et la complexification de ces étapes, non seulement, augmentent le risque de désalignement des couches de matériaux formant les composants des dispositifs micro- et nano-électroniques, ce qui conduit à une perte de rendement, mais aussi, augmentent le coût de fabrication de ces dispositifs micro- et nano-électroniques, notamment à cause de la nécessité d'utiliser des équipements de plus en plus onéreux.

Il existe donc un besoin de développer un nouveau procédé de structuration de couches de matériaux permettant de réduire le nombre d'étapes dans la fabrication de composants pour des dispositifs micro- et nano-électroniques, par rapport aux procédés déjà connus.

### EXPOSÉ DE L'INVENTION

L'invention vise justement à fournir un tel procédé.

L'invention a donc pour objet, en premier lieu, un procédé de structuration d'une couche fonctionnelle, le procédé comprenant au moins les étapes suivantes :
a) fourniture d'un substrat ayant une surface recouverte localement par une couche dite sacrificielle en un matériau lithié, une ou plusieurs zones de la surface du substrat étant dépourvues de la couche sacrificielle ;
b) croissance de la couche fonctionnelle de manière sélective sur la ou les zones de la surface du substrat dépourvues de la couche sacrificielle, la couche fonctionnelle étant obtenue à partir d'un précurseur halogéné comprenant du chlore, de l'iode ou du brome, de préférence du chlore ;
c) élimination de la couche sacrificielle ;
moyennant quoi la surface du substrat est recouverte par une couche fonctionnelle structurée.

On précise que, dans ce qui précède et ce qui suit, on entend par « *structuration »* le fait de délimiter, de manière sélective, le dépôt d'une couche sur une zone prédéterminée et, avantageusement, le fait de lui donner la forme d'un motif souhaité.

Par ailleurs, dans ce qui précède et ce qui suit, on entend par « *croissance* » le fait que la couche fonctionnelle puisse se déposer et croître sur la surface d'un matériau sous-jacent, de manière à présenter une épaisseur souhaitée homogène sur toute cette surface.

L'invention se distingue fondamentalement de l'art antérieur par la mise en oeuvre d'une couche sacrificielle. La couche sacrificielle est en un matériau de nature à retarder, voire empêcher, la croissance de la couche fonctionnelle. La vitesse de croissance de la couche fonctionnelle sur la couche sacrificielle est nulle ou inférieure à la vitesse de croissance de la couche fonctionnelle sur le substrat. Lorsque les précurseurs de la couche fonctionnelle sont déposés sur la couche sacrificielle, une interaction entre les composés présents dans la couche sacrificielle et ces précurseurs a lieu, entraînant alors un retard voire une absence de croissance des premières couches atomiques de la couche fonctionnelle.

Ainsi, la ou les zones de la surface du substrat qui sont dépourvues de la couche sacrificielle permettent d'obtenir des zones favorables à la croissance de la couche fonctionnelle, tandis que la ou les zones recouvertes par la couche sacrificielle sont des zones dites défavorables à la croissance de la couche fonctionnelle.

Avantageusement, la couche sacrificielle est en un oxyde de lithium ou un oxynitrure de lithium, par exemple choisi parmi LiPON, Li₂SiO₃, LiPO, LiSiPON, LiAlO₂, LiOH, Li₂O et Li₂CO₃, préférence étant toutefois donnée au LiPON.

Selon un premier mode de réalisation de l'invention, la couche fonctionnelle peut être une couche électrique (ou aussi dite couche conductrice) en un nitrure métallique tel que du nitrure de titane, du nitrure de tantale, du nitrure de molybdène ou du nitrure de tungstène, préférence étant toutefois donnée au nitrure de titane. Par exemple, une couche de TiN obtenue à partir d'un précurseur halogéné présente une résistivité électrique faible, typiquement une résistivité électrique généralement inférieure à 500 µΩ cm. Une telle couche peut être utilisée en tant qu'électrode dans une capacité MIM.

Selon un deuxième mode de réalisation de l'invention, la couche fonctionnelle peut être une couche diélectrique en un oxyde métallique choisi de préférence parmi l'oxyde d'hafnium, l'oxyde de silicium, l'oxyde de zirconium et l'oxyde de titane, préférence étant toutefois donnée à l'oxyde d'hafnium. Une telle couche peut être utilisée en tant que couche électriquement isolante dans une capacité MIM.

Conformément à l'invention, l'étape a) du procédé comprend, de préférence, les sous-étapes suivantes :
i) dépôt de la couche sacrificielle sur tout ou partie de la surface du substrat, de préférence par la technique de dépôt par couche atomique (ou dit ALD pour « *Atomic Layer Deposition* » en anglais) ;
ii) élimination partielle de la couche sacrificielle en des endroits prédéterminés par gravure au plasma, gravure humide ou par gravure laser, préférence étant donnée à la gravure au plasma.

Plus particulièrement, la couche sacrificielle est déposée, de préférence, par ALD, généralement à une température comprise entre 200 °C et 450 °C, par exemple à 300 °C et sous vide (de quelques mTorr à quelques Torr ; soit entre environ 0,1 Pa et quelques centaines de Pa, par exemple 300 Pa) ce qui permet notamment d'obtenir des couches très conformables, de très haute pureté et de très faible épaisseur.

Le principe du dépôt par ALD réside dans le fait d'introduire dans une chambre ALD au moins deux espèces réactives, dites « *précurseurs* », puis de les faire circuler de manière alternée sur la surface d'un matériau.

Le choix des précurseurs dépend de la nature souhaitée de la couche à déposer.

Par exemple, pour déposer une couche sacrificielle en un matériau lithié, les précurseurs généralement utilisés sont de l'hexaméthyldisilazane de lithium (noté LiHMDS) couplé avec du phosphoramidate de diétyle (noté DEPA), du tert-butylate de lithium (noté LiOtBu) couplé avec du DEPA ou encore du LiOtBu couplé avec du phosphite de triméthyle (noté TMPO), pour l'obtention d'une couche en oxynitrure de phosphore de lithium (ou LiPON).

Il est aussi possible d'utiliser, par exemple, du LiOtBu couplé avec de l'orthosilicate de tétraéthyle (noté TEOS) et de l'eau ce qui permet l'obtention d'une couche en métasilicate de lithium (ou Li₂SiO₃).

Après l'introduction et la circulation alternée de chacun des précurseurs, une étape de purge de ceux-ci est généralement mise en oeuvre, par exemple pendant une durée d'au moins 35 secondes, pour éliminer les précurseurs en excès et les éventuels sous-produits non désirés, obtenus lors d'une réaction entre les précurseurs.

Par ailleurs, l'introduction et la circulation alternée peuvent être répétées un certain nombre de fois jusqu'à l'obtention d'une épaisseur souhaitée.

Selon l'invention, la couche sacrificielle ainsi déposée sur tout ou partie de la surface du substrat présente typiquement une épaisseur comprise entre 1 nm et 50 nm et, plus généralement, entre 1 nm et 5 nm, par exemple égale à 2 nm. Cette faible épaisseur suffit pour inhiber la croissance de la couche sus-jacente obtenue à partir d'un halogénure.

Une telle couche sacrificielle comprenant du lithium est avantageusement utilisée dans le cadre de l'invention car elle présente l'avantage d'être facilement éliminée par des solutions de gravure standards telles que la gravure au plasma.

Il est ainsi possible de mettre en oeuvre la sous-étape ii) par gravure au plasma, par exemple avec un plasma fluoré (qui peut comprendre du trifluorométhane) ou avec un plasma chloré (qui peut comprendre du dichlore) et en utilisant un masque dur en un matériau adapté, tel que du titane, de l'aluminium ou du nickel et une couche d'arrêt par exemple une couche en oxyde de silicium, présentant un ou plusieurs motifs de manière, d'une part, à protéger certaines parties de la couche sous-jacente et, d'autre part, à en exposer d'autres au plasma.

Ainsi, les parties protégées par le masque dur et la couche d'arrêt ne sont pas attaquées par le plasma et donc ne sont pas éliminées, tandis que les parties n'étant pas protégées par le masque dur et la couche d'arrêt sont attaquées et donc éliminées par la gravure au plasma.

Cette sous-étape d'élimination partielle permet ainsi d'obtenir et de sélectionner la ou les zones de la surface dépourvues de la couche sacrificielle. En d'autres termes cette sous-étape permet de sélectionner la ou les zones favorables et la ou les zones défavorables à la croissance de la couche fonctionnelle, ce qui permet, en conséquence, de délimiter et de localiser de manière sélective les dépôts de couches de matériaux et notamment de couches obtenues à partir d'au moins un halogénure.

De plus, on préfère que l'étape b) s'effectue par ALD. Au moins un des précurseurs de la couche fonctionnelle est un halogénure comprenant du chlore, de l'iode ou du brome, préférence étant donnée au chlore.

Lorsque la couche fonctionnelle est une couche électrique en un nitrure métallique, le dépôt par ALD est typiquement réalisé à une température comprise entre 200 °C et 450 °C, par exemple à 400 °C.

Comme mentionné précédemment, les précurseurs utilisés lors d'un dépôt par ALD sont choisis en fonction de la nature souhaitée de la couche. Par exemple, du tétrachlorure de titane (TiCl₄) peut être couplé avec de l'ammoniac pour obtenir une couche électrique en nitrure de titane (TiN).

Lorsque la couche fonctionnelle est une couche diélectrique en un oxyde métallique, le dépôt par ALD peut être réalisé à une température comprise entre 200 °C et 450 °C, par exemple à 300 °C.

Par exemple, les précurseurs généralement utilisés pour obtenir une couche en oxyde d'hafnium sont le tétrachlorure d'hafnium (HfCl₄) couplé avec de l'eau.

Il est aussi possible d'utiliser comme précurseurs du tétrachlorure de silicium (SiCl₄) couplé avec de l'eau pour obtenir une couche diélectrique en oxyde de silicium ou encore du tétrachlorure de zirconium (ZrCl₄) couplé avec de l'eau pour l'obtention d'une couche en oxyde de zirconium ou bien du tétrachlorure de titane (TiCl₄) couplé avec de l'eau pour l'obtention d'une couche en oxyde de titane.

Un homme du métier saura parfaitement adapter le ou les précurseurs comprenant l'halogénure en fonction de la nature de la couche fonctionnelle souhaitée.

Habituellement, lors du dépôt par ALD d'une couche fonctionnelle, l'introduction de chacun des précurseurs est suivie d'un temps, dit temps d'attente, avant de réaliser une purge de ceux-ci.

Le temps d'attente représente le temps de résidence des précurseurs à la surface du substrat ou, le cas échant, à la surface d'une couche sous-jacente. Le temps d'attente permet de faire diffuser et faire réagir les précurseurs de façon optimale, notamment dans des structures complexes comprenant par exemple un substrat avec une surface microstructurée.

Dans le cadre de l'invention, le temps d'attente peut par exemple être fixé entre 15 secondes et 100 secondes et plus particulièrement fixé à 30 secondes tandis que la purge peut être mise en oeuvre par exemple pendant au moins 35 secondes.

Comme pour la couche sacrificielle, l'introduction et la circulation alternée des précurseurs, permettant le dépôt de la couche fonctionnelle, peuvent être répétées un certain nombre de fois jusqu'à l'obtention d'une épaisseur souhaitée de la couche.

Dans le cadre de l'invention, la couche fonctionnelle est une couche ultramince et peut présenter une épaisseur comprise entre 3 nm et 100 nm, plus généralement comprise entre 5 nm et 20 nm, par exemple égale à 10 nm.

D'autre part, conformément à l'invention, l'étape c) du procédé, consistant à éliminer la couche sacrificielle est, de préférence, effectuée par gravure au plasma, gravure humide ou gravure laser, préférence étant toutefois donnée à la gravure au plasma, et encore plus préférentiellement à une gravure au plasma qui comprend du fluor, tel que du trifluorométhane ou à une gravure au plasma qui comprend du chlore, tel que du dichlore, préférence étant donnée au fluor.

De telles techniques de gravure permettent d'éliminer facilement la couche sacrificielle sans pour autant altérer les propriétés de toute autre couche fonctionnelle présente sur le substrat.

Il est à noter que la couche sacrificielle a pour rôle de retarder voire d'inhiber la croissance de la couche fonctionnelle, une très faible épaisseur de cette couche fonctionnelle est donc susceptible d'être déposée sur la couche sacrificielle. Cependant, ceci ne nuirait en aucun cas au procédé de l'invention puisque la couche fonctionnelle déposée serait éliminée en même temps que la couche sacrificielle lors l'étape c), du fait de sa très faible épaisseur. Par très faible épaisseur, on entend une épaisseur inférieure à 3 nm et, mieux encore, inférieure à 1 nm.

Par ailleurs, la surface du substrat peut par exemple être plane - c'est-à-dire en deux dimensions - ou peut comprendre une ou plusieurs zones planes et une ou plusieurs zones microstructurées - c'est-à-dire en trois dimensions.

Dans ce qui précède et ce qui suit, on entend par « *zone microstructurée* » une zone de la surface comprenant des pores ou des vias, par exemple de forme allongée, ce qui permet notamment d'augmenter la surface spécifique du substrat - c'est-à-dire la surface du substrat destinée à être recouverte notamment par la couche fonctionnelle - par rapport à une zone plane.

Ainsi, une surface comprenant une ou plusieurs zones planes et une ou plusieurs zones microstructurées peut présenter un rapport d'aspect plus ou moins important, ce rapport d'aspect correspondant au rapport de la dimension longitudinale sur la dimension transversale des pores ou des vias. Aussi, plus le rapport d'aspect est élevé, plus la surface spécifique du substrat est importante. Par exemple, un rapport d'aspect supérieur à 20 peut être envisagé.

Plus particulièrement, on préfère que la surface du substrat comprenne une ou plusieurs zones planes et une ou plusieurs zones microstructurées. Dans ce cas, la surface du substrat est avantageusement recouverte par la couche sacrificielle uniquement sur sa ou ses zones planes tandis que la ou les zones microstructurées sont dépourvues de la couche sacrificielle, en conséquence de quoi la croissance de la couche fonctionnelle (étape b) du procédé) se fera de manière sélective sur les zones microstructurées.

Généralement, le substrat peut être en silicium, en nitrure métallique ou en un matériau à base d'oxyde métallique tel que l'alumine ou en tout autre matériau adapté.

Le procédé est particulièrement avantageux dans le cadre de fabrication de capacitances de type MIM, puisqu'il permet de réduire le nombre d'étapes de la fabrication d'une structure telle qu'une capacitance de type MIM.

En particulier, le procédé peut être mis en oeuvre pour structurer au moins une des électrodes de la capacitance de type MIM et/ou pour structurer la couche électriquement isolante de la capacitance de type MIM.

L'invention a-t-elle aussi pour objet un procédé de préparation d'une capacitance de type Métal-Isolant-Métal qui comprend au moins les étapes suivantes :
- structuration d'une couche fonctionnelle électrique (première électrode, aussi appelée électrode inférieure) en mettant en oeuvre le procédé tel que défini précédemment ;
- dépôt d'une couche diélectrique ;
- dépôt d'une autre couche électrique (deuxième électrode, aussi appelée électrode supérieure), identique ou différente de la première couche fonctionnelle électrique, de préférence identique.

Conformément au procédé de préparation ci-dessus défini, la couche fonctionnelle électrique peut être en un nitrure métallique, tel que du nitrure de titane, du nitrure de tantale, du nitrure de molybdène ou du nitrure de tungstène, cette couche étant obtenue à partir d'un halogénure.

Dans ce cas particulier, la couche diélectrique et l'autre couche électrique (deuxième électrode) ne sont pas nécessairement obtenues à partir d'un halogénure, étant entendu qu'elles ne sont pas destinées à être structurées.

Par exemple, la couche diélectrique peut être en un matériau à haute permittivité, tel que de l'oxyde d'hafnium, de l'oxyde de silicium, de l'oxyde de zirconium ou de l'oxyde de titane ou alors elle peut être une couche diélectrique ionique, par exemple, en LiPON, LiSiPON, LiAlO₂, LATP ou en un matériau dit LGPS, LPS ou encore LLZO.

L'autre couche électrique (deuxième électrode), quant à elle, peut par exemple être en un nitrure métallique, identique ou différent de celui de la couche fonctionnelle électrique.

Ainsi, la couche fonctionnelle de la capacitance de type MIM obtenue est structurée, notamment grâce au phénomène de retard ou d'absence de croissance de cette couche fonctionnelle dû à la présence de la couche sacrificielle.

L'invention a aussi pour objet un procédé de préparation d'une capacitance de type Métal-Isolant-Métal qui comprend au moins les étapes suivantes :
- structuration d'une couche fonctionnelle diélectrique en mettant en oeuvre le procédé tel que défini précédemment, le substrat fourni à l'étape a) comprenant un substrat support et une première couche électrique (première électrode), la première couche électrique étant recouverte localement par la couche sacrificielle,
- dépôt d'une deuxième couche électrique (deuxième électrode) sur la couche fonctionnelle diélectrique ainsi structurée, la deuxième couche électrique étant identique ou différente de la première couche électrique, de préférence identique.

Conformément au procédé défini ci-dessus, la première et la deuxième couche électrique ne sont pas nécessairement obtenues à partir d'un halogénure. Elles peuvent être identiques ou différentes, en un métal tel que le titane, le platine, le tungstène, le ruthénium, ou le molybdène ou en un nitrure métallique tel que le nitrure de titane, le nitrure de tantale, le nitrure de tungstène ou le nitrure de molybdène.

L'invention a-t-elle aussi pour objet un procédé de préparation d'une capacitance de type Métal-Isolant-Métal qui comprend au moins une étape correspondant à la structuration d'une couche fonctionnelle électrique (deuxième électrode) en mettant en oeuvre le procédé tel que défini précédemment, le substrat fourni à l'étape a) comprenant successivement un substrat support, une première couche électrique (première électrode) et une couche diélectrique, la première couche électrique étant identique ou différente de la couche fonctionnelle électrique, de préférence identique et la couche diélectrique étant recouverte localement par la couche sacrificielle.

Conformément au procédé défini ci-dessus, la première couche électrique et la couche diélectrique ne sont pas nécessairement obtenues à partir d'un halogénure.

Par exemple la première couche électrique peut être en un métal tel que le titane, le platine, le tungstène, le ruthénium ou le molybdène ou en un nitrure métallique tel que le nitrure de titane, le nitrure de tantale, le nitrure de tungstène ou le nitrure de molybdène.

La couche diélectrique, quant à elle, peut être en un matériau à haute permittivité, tel que de l'oxyde d'hafnium, de l'oxyde de silicium, de l'oxyde de zirconium ou de l'oxyde de titane ou alors elle peut être une couche diélectrique ionique, par exemple en LiPON, LiSiPON, LiAlO₂, LATP ou en un matériau dit LGPS, LPS ou encore LLZO.

Il est à noter que, selon les procédés de préparation de capacitances de type MIM et dans le cas où la structure du substrat comprend une ou plusieurs zones planes et une ou plusieurs zones microstructurées, alors la capacitance de type MIM est obtenue seulement sur la ou les zones microstructurées.

Par ailleurs, lors d'un procédé de préparation d'une capacitance de type MIM, le dépôt de chacune des couches est avantageusement réalisé par la technique de dépôt par ALD tel que décrit précédemment, en adaptant les précurseurs en fonction de la nature souhaitée des couches à déposer.

Alternativement au dépôt par ALD, un dépôt par ALD assisté par plasma (aussi dit PEALD pour « *Plasma Enhanced Atomic Loyer Déposition* »), un dépôt par ALD spatiale (aussi dit SALD pour « *Spatial Atomic Loyer Déposition* ») ou encore un dépôt par ALD à pression atmosphérique peuvent être mis en oeuvre.

D'autres alternatives peuvent être mises en oeuvre, telles que des techniques de dépôt adaptées aux couches minces, comme le dépôt physique en phase vapeur (ou PVD pour « *Physical VapourDeposition* ») ou encore comme le dépôt chimique en phase vapeur (ou CVD pour « *Chemical Vapour Déposition* »)*.*

L'homme du métier sait parfaitement choisir le procédé de dépôt le plus adapté en fonction de la surface du substrat utilisé (zones planes et/ou microstructurées).

Il est à noter qu'il est également possible de structurer plusieurs couches fonctionnelles d'une capacitance de type MIM dans le même procédé, étant entendu que ces couches fonctionnelles soient toutes obtenues à partir d'au moins un halogénure.

Par exemple pour fournir une capacitance de type MIM en structurant une première couche fonctionnelle électrique et une deuxième couche fonctionnelle diélectrique il est possible de réaliser les étapes suivantes :
- fournir un substrat ayant une surface recouverte localement par une couche sacrificielle, une ou plusieurs zones de la surface du substrat étant dépourvues de la couche sacrificielle ;
- croissance de la première couche fonctionnelle électrique de manière sélective sur la ou les zones de la surface du substrat dépourvues de la couche sacrificielle ;
- croissance de la deuxième couche fonctionnelle diélectrique de manière sélective sur la ou les zones de la surface du substrat dépourvues de la couche sacrificielle ;
- élimination de la couche sacrificielle ; et
- dépôt d'autre autre couche électrique, identique ou différente de la première couche fonctionnelle électrique.

Il va de soi qu'en fonction de la ou des couches fonctionnelles à structurer dans une capacitance de type MIM, l'homme du métier est parfaitement capable d'adapter le procédé de structuration tel que défini précédemment.

L'invention est particulièrement avantageuse pour structurer des couches ultraminces (ayant typiquement des épaisseurs inférieures à 50 nm), et/ou pour des structures présentant des surfaces microstructurées, c'est-à-dire des surfaces développées très importantes ayant un rapport d'aspect supérieur à 20 voire supérieur à 50. L'invention est particulièrement avantageuse pour fabriquer des structures MIM formées de couches ultraminces.

Néanmoins, l'invention peut être mise en oeuvre pour structurer des couches ayant des épaisseurs pouvant aller jusqu'à 100 nm. D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES FIGURES

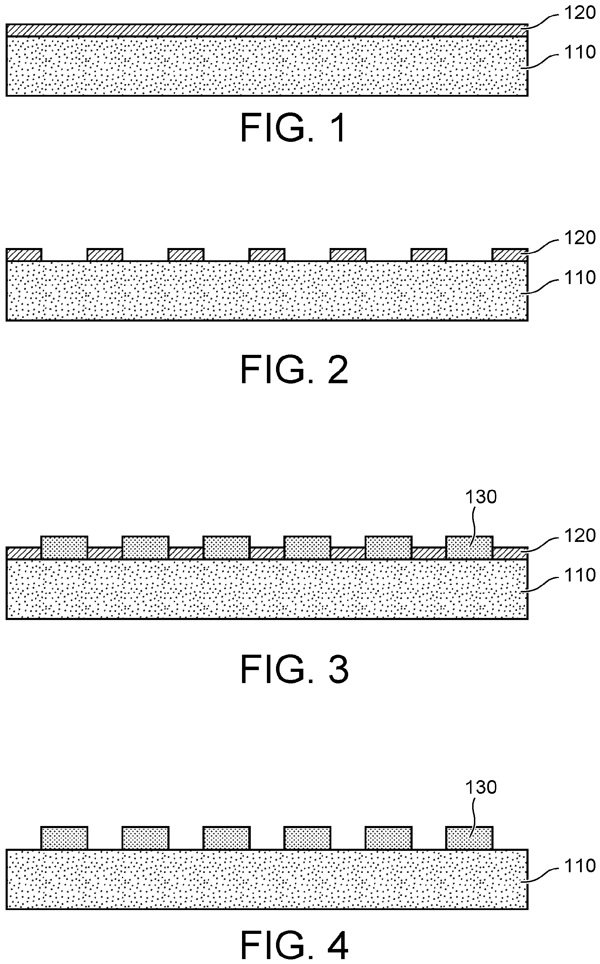

La figure 1 représente un substrat 110 ayant une surface plane recouverte d'une couche sacrificielle 120, selon une étape d'un procédé de fabrication d'une couche électrique structurée selon le premier exemple de réalisation de l'invention.
La figure 2 représente une structure comprenant le substrat 110 dont sa surface est recouverte localement par la couche sacrificielle 120 en LiPON.
La figure 3 représente une structure comprenant le substrat 110 dont sa surface est recouverte localement d'une part, par la couche sacrificielle 120 et, d'autre part, par une couche fonctionnelle électrique 130, selon une autre étape du procédé de fabrication d'une couche électrique structurée selon le premier exemple de réalisation de l'invention.
La figure 4 représente une structure comprenant le substrat 110 dont sa surface est recouverte localement par la couche fonctionnelle électrique 130, selon une autre étape du procédé de fabrication d'une couche électrique structurée selon le premier exemple de réalisation de l'invention.

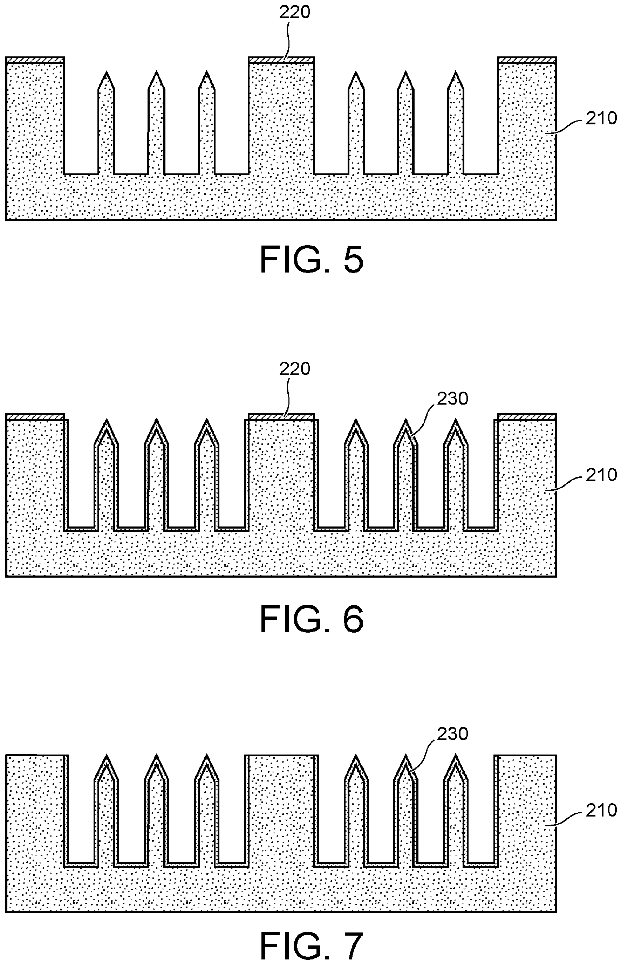

La figure 5 représente un substrat 210 ayant une surface comprenant des zones planes et des zones microstructurées et dont les zones planes uniquement sont recouvertes par une couche sacrificielle 220, selon une étape d'un procédé de fabrication d'une structure MIM selon un deuxième exemple de réalisation de l'invention.
La figure 6 représente une structure comprenant le substrat 210 dont les zones planes de sa surface sont recouvertes par la couche sacrificielle 220 et dont les zones microstructurées de sa surface sont recouvertes par une couche fonctionnelle électrique 230, selon une autre étape du procédé de fabrication d'une structure MIM selon le deuxième exemple de réalisation de l'invention.
La figure 7 représente une structure comprenant le substrat 210 dont seules les zones microstructurées de sa surface sont recouvertes par la couche fonctionnelle électrique 230, selon une autre étape du procédé de fabrication d'une structure MIM selon le deuxième exemple de réalisation de l'invention.

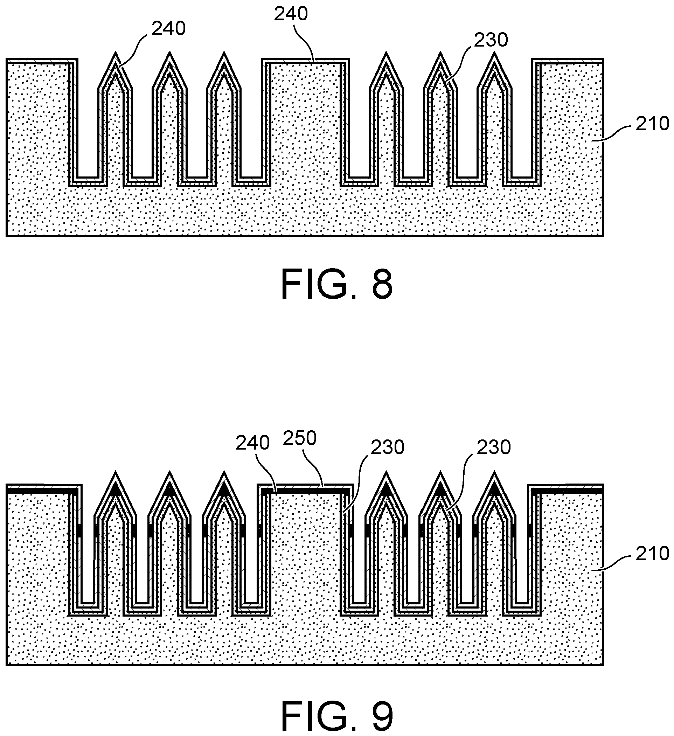

La figure 8 représente une structure comprenant le substrat 210 dont les zones microstructurées de sa surface sont recouvertes par un empilement de la couche fonctionnelle 230 et d'une couche diélectrique 240 et dont les zones planes de sa surface sont recouvertes uniquement par la couche diélectrique 240, selon une autre étape du procédé de fabrication d'une structure MIM selon le deuxième exemple de réalisation de l'invention.
La figure 9 représente une structure comprenant le substrat 210 dont les zones planes de sa surface sont recouvertes uniquement par un empilement de la couche diélectrique 240 et d'une couche électrique 250 et dont les zones microstructurées de sa surface sont recouvertes par une capacitance de type MIM, c'est-à-dire recouvertes par un empilement de la couche fonctionnelle électrique 230, de la couche diélectrique 240 et de la couche électrique 250, selon une autre étape du procédé de fabrication d'une structure MIM selon le deuxième exemple de réalisation de l'invention..

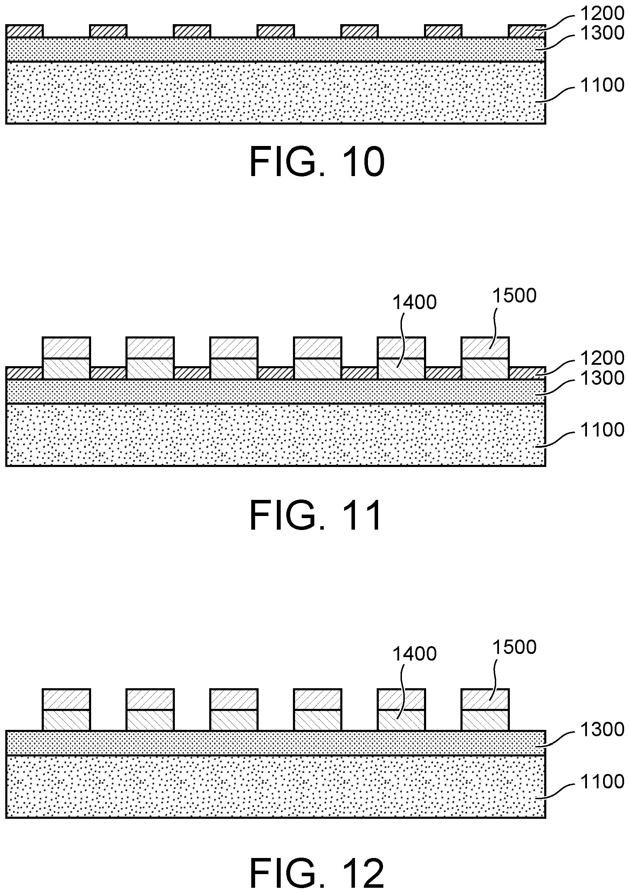

La figure 10 représente une structure comprenant un substrat 1100 dont sa surface est recouverte par une première couche électrique 1300 et dont la surface de cette couche électrique 1300 est recouverte localement par une couche sacrificielle 1200, selon une étape d'un procédé de fabrication d'une structure MIM selon un troisième exemple de réalisation de l'invention.
La figure 11 représente une structure comprenant le substrat 1100 dont sa surface est recouverte par la première couche électrique 1300, la surface de cette couche électrique 1300 étant recouverte localement, d'une part, par la couche sacrificielle 1200 et, d'autre part, par un empilement d'une couche fonctionnelle diélectrique 1400 et d'une couche fonctionnelle électrique 1500, selon une autre étape du procédé de fabrication d'une structure MIM selon le troisième exemple de réalisation de l'invention.
La figure 12 représente une structure comprenant le substrat 1100 dont sa surface est recouverte par la première couche électrique 1300, la surface de cette couche électrique 1300 étant recouverte localement par un empilement de la couche fonctionnelle diélectrique 1400 et de la couche fonctionnelle électrique 1500; les zones comprenant l'empilement de ces trois couches correspondent à une capacitance de type MIM, selon une autre étape du procédé de fabrication d'une structure MIM selon le troisième exemple de réalisation de l'invention.

Il est à noter que les figures décrites ci-dessus sont des représentations schématiques dont les dimensions et proportions relatives des substrats et de l'une quelconque des couches ne sont pas représentatives de celles susceptibles d'être présentées en situation réelle et ce, pour des questions de lisibilité.

### EXPOSÉ DÉTAILLÉ DE MODES DE RÉALISATION PARTICULIERS

### EXEMPLE 1 : STRUCTURATION D'UNE COUCHE FONCTIONNELLE ÉLECTRIQUE EN TIN

### 1.1 - Dépôt d'une couche sacrificielle en LiPON :

Un substrat 110 est placé dans une chambre ALD sous vide, à 0,3 Pa, dédiée aux dépôts de couches diélectriques ioniques.

Le substrat 110 est en silicium avec une isolation électrique en oxyde de silicium et présente une surface plane.

Un dépôt par ALD est mis en oeuvre à une température de 300 °C en réalisant 20 fois le cycle d'étapes suivantes :
- injection et circulation de LiHMDS sur la surface du substrat 110 pendant une durée d'injection égale à 4 secondes ;
- purge pendant 35 secondes du LiHMDS en excès ; puis
- injection et circulation de DEPA sur la surface du substrat 110 pendant une durée d'injection égale à 2 secondes ;
- purge pendant 35 secondes du DEPA en excès ainsi que des éventuels sous-produits obtenus lors d'une réaction entre le LiHMDS et le DEPA.

Ainsi, une couche sacrificielle 120 en LiPON, d'une épaisseur de 2 nm, est déposée de manière homogène sur toute la surface du substrat 110, comme illustré sur la figure 1.

### 1.2 - Élimination partielle de la couche sacrificielle en LiPON :

L'ensemble formé par le substrat 110 et la couche sacrificielle 120 en LiPON est placé dans une chambre sous une pression de 1 Pa.

Un masque dur en titane et une couche d'arrêt en SiO₂ sont placés sur la surface de la couche sacrificielle 120.

Une méthode de gravure au plasma, avec un plasma fluoré à base de CHF₃ est mise en oeuvre pendant 10 secondes puis le masque et la couche d'arrêt sont retirés.

Ainsi, les parties de la couche sacrificielle 120 en LiPON non recouvertes par le masque dur et la couche d'arrêt sont éliminées par la gravure tandis que les parties protégées par le masque et la couche d'arrêt n'ont pas été attaquées par le plasma et donc n'ont pas été éliminées par la gravure.

Une structure comprenant le substrat 110 dont sa surface est recouverte localement par la couche sacrificielle 120 en LiPON avec un motif tel que représenté à la figure 2, est obtenue.

### 1.3 - Croissance de la couche fonctionnelle électrique en TiN :

Tout en restant sous vide, l'ensemble formé par le substrat 110 et la couche sacrificielle 120, tel qu'obtenu au point 1.2, est déplacé vers une chambre ALD dédiée aux dépôts de couches d'électrodes.

Un dépôt par ALD est mis en oeuvre à une température de 400 °C en introduisant et en faisant circuler de manière alternée du TiCl₄ et du NH₃ sur l'ensemble formé par le substrat 110 et la couche sacrificielle 120 obtenu au point 1.2.

L'introduction et la circulation alternée du TiCl₄ et du NH₃ sont chacune mises en oeuvre et répétées 200 fois, avec un temps d'injection de 2 secondes et en respectant un temps d'attente de 30 secondes et une purge de 35 secondes.

Ainsi la couche fonctionnelle électrique 130 en TiN, d'une épaisseur de 10 nm, est déposée sur la surface de l'ensemble formé par le substrat 110 et la couche sacrificielle 120 obtenu au point 1.2.

Cette couche fonctionnelle 130 n'est finalement présente que sur les parties de la surface du substrat 110 qui sont dépourvues de la couche sacrificielle 120, comme illustré sur la figure 3, puisque la couche 120 en LiPON inhibe la croissance de la couche fonctionnelle électrique 130.

### 1.4 - Élimination de la couche sacrificielle en LiPON :

L'ensemble obtenu au point 1.3 ci-avant est placé dans une chambre sous une pression de 1 Pa.

Une méthode de gravure au plasma, avec un plasma fluoré à base de CHF₃, est mise en oeuvre pendant 10 secondes, éliminant ainsi la totalité de la couche sacrificielle 120 en LiPON.

Ainsi, une structure telle qu'illustrée sur la figure 4 est obtenue. Cette structure comprend le substrat 110 dont sa surface est localement recouverte, de façon sélective, par la couche fonctionnelle électrique 130 en TiN.

### EXEMPLE 2 : PRÉPARATION D'UNE PREMIÈRE CAPACITANCE DE TYPE MIM EN STRUCTURANT SA COUCHE FONCTIONNELLE ÉLECTRIQUE EN TIN

### 2.1- Dépôt d'une couche sacrificielle en LiPON :

Un substrat 210 est placé dans une chambre ALD sous vide dédiée aux dépôts de couches diélectriques ioniques.

Le substrat 210 est en silicium isolé électriquement avec un oxyde de silicium. Il présente une surface comprenant des zones planes et des zones microstructurées de manière à lui conférer un rapport d'aspect supérieur à 20.

Un dépôt par ALD est mis en oeuvre à une température de 300 °C en introduisant et en faisant circuler de manière alternée du LiHMDS et du DEPA sur la surface du substrat 210.

L'introduction et la circulation alternée du LiHMDS et du DEPA sont chacune mises en oeuvre et répétées 20 fois, avec un temps d'injection de 4 secondes.

Une purge est réalisée pendant 35 secondes après chaque introduction et circulation alternée du LiHMDS et de DEPA.

Une couche sacrificielle 220 en LiPON d'une épaisseur de 2 nm est ainsi obtenue.

Du fait du fort rapport d'aspect (supérieure à 20) du substrat 210, la couche sacrificielle 220 en LiPON est déposée uniquement sur les zones planes de cette surface, tel que représenté à la figure 5.

Aussi, en utilisant un tel substrat et un dépôt par ALD avec les conditions décrites ci-dessus, le dépôt de la couche sacrificielle 220 est réalisé de manière localisée. Aucune étape d'élimination partielle, par exemple par gravure au plasma, n'est nécessaire. Cependant il pourrait être envisageable de recourir à une telle étape sur les zones planes du substrat 210, pour obtenir de nouvelles parties de la surface du substrat 210 dépourvues de la couche sacrificielle 220.

### 2.2- Croissance de la couche fonctionnelle électrique en TiN (première électrode) :

Tout en restant sous vide, l'ensemble formé par le substrat 210 et la couche sacrificielle 220, tel qu'obtenu au point 2.2, est déplacé vers une chambre ALD dédiée aux dépôts de couches d'électrodes.

Un dépôt par ALD est mis en oeuvre avec les mêmes conditions que celles décrites au point 1.3 ci-avant.

Ainsi, comme représenté sur la figure 6, la couche fonctionnelle électrique 230 en TiN, d'une épaisseur de 10 nm, est déposée, de manière sélective, sur les zones microstructurées de la surface du substrat 210, les zones planes de cette surface comprenant la couche sacrificielle qui inhibe la croissance de la couche fonctionnelle 230.

### 2.3- Élimination de la couche sacrificielle en LiPON :

L'ensemble obtenu au point 2.2 ci-avant est placé dans une chambre sous une pression de 1 Pa.

Une méthode de gravure au plasma, avec un plasma fluoré à base de CHF₃, est mise en oeuvre pendant 10 secondes, éliminant ainsi la totalité de la couche sacrificielle 220 en LiPON.

Une structure telle qu'illustrée sur la figure 7 est obtenue. Cette structure comprend le substrat 210 dont seules les zones microstructurées de sa surface sont recouvertes par la couche fonctionnelle électrique 230 en TiN.

### 2.4- Dépôt d'une couche diélectrique en HfO₂ :

Tout en restant sous vide, l'ensemble formé par le substrat 210 et la couche fonctionnelle électrique 230 en TiN, tel qu'obtenu au point 2.3 ci-avant, est déplacé vers une chambre ALD, dédiée aux dépôts de couches diélectriques.

Un dépôt par ALD est mis en oeuvre à une température de 300 °C en introduisant et en faisant circuler de manière alternée du HfCl₄ et de l'eau sur l'ensemble formé au point 2.3.

L'introduction et la circulation alternée du HfCl₄ et de l'eau sont chacune mises en oeuvre et répétées 165 fois, avec un temps d'injection de 2 secondes et en respectant un temps d'attente de 30 secondes et une purge de 35 secondes.

Ainsi, une couche diélectrique 240 en HfO₂ d'une épaisseur de 10 nm est déposée sur l'ensemble obtenu au point 2.3.

La structure ainsi obtenue est représentée sur la figure 8, qui comprend le substrat 210 dont les zones microstructurées de sa surface sont recouvertes par un empilement de la couche fonctionnelle 230 en TiN et de la couche diélectrique 240 en HfO₂ et dont les zones planes de sa surface sont recouvertes uniquement par la couche diélectrique 240 en HfO₂.

### 2.5- Dépôt d'une couche électrique en TiN :

Tout en restant sous vide, l'ensemble formé par le substrat 210, la couche fonctionnelle 230 en TiN et la couche diélectrique 240 en HfO₂, tel qu'obtenu au point 2.4 ci-avant, est déplacé vers une chambre ALD, dédiée aux dépôts de couches d'électrodes.

Une couche électrique 250 en TiN, d'une épaisseur de 10 nm, est déposée sur la surface de l'ensemble obtenu au point 2.4, en mettant en oeuvre un dépôt par ALD dans les mêmes conditions que celles décrites au point 2.2 ci-avant.

Ainsi, une structure telle que représentée sur la figure 9 est obtenue. Cette structure comprend le substrat 210 dont les zones planes de sa surface sont recouvertes uniquement par un empilement de la couche diélectrique 240 en HfO₂ et de la couche électrique 250 en TiN et dont les zones microstructurées de sa surface sont recouvertes par un empilement de la couche fonctionnelle électrique 230 en TiN, de la couche diélectrique 240 en HfO₂ et de la couche électrique 250 en TiN.

Ainsi, une capacitance de type MIM est obtenue sur les zones microstructurées de la surface du substrat 210.

### EXEMPLE 3: PRÉPARATION D'UNE DEUXIÈME CAPACITANCE DE TYPE MIM EN STRUCTURANT SES COUCHES FONCTIONNELLES DIÉLECTRIQUE EN HFOz ET ÉLECTRIQUE EN TIN

### 3.1- Dépôt d'une première couche électrique en TiN (première électrode) :

Un substrat 1100 est placé dans une chambre ALD sous vide dédiée aux dépôts de couches électriques.

Le substrat 1100 est en silicium isolé électriquement avec un oxyde de silicium et présente une surface plane.

Un dépôt par ALD est mis en oeuvre à une température de 400 °C en introduisant et en faisant circuler de manière alternée du TiCl₄ et du NH₃ sur la surface du substrat 1100.

L'introduction et la circulation alternée du TiCl₄ et du NH₃ sont chacune mises en oeuvre et répétées 200 fois, avec un temps d'injection de 2 secondes et en respectant un temps d'attente de 30 secondes et une purge de 35 secondes.

Ainsi, une première couche électrique 1300 en TiN, d'une épaisseur de 10 nm, est déposée sur la surface du substrat 1100.

### 3.2- Dépôt d'une couche sacrificielle en LiPON :

Tout en restant sous vide, l'ensemble formé par le substrat 1100 et la première couche électrique 1300 en TiN, tel qu'obtenu au point 3.1 ci-avant, est déplacé vers une chambre ALD, dédiée aux dépôts de couches diélectriques.

Un dépôt par ALD est mis en oeuvre dans les mêmes conditions que celles décrites au point 1.1.

Ainsi, une couche sacrificielle 1200 en LiPON d'une épaisseur de 2 nm est déposée sur la surface de la première couche électrique 1300 en TiN.

### 3.3- Élimination partielle de la couche sacrificielle en LiPON :

L'ensemble formé par le substrat 1100, la première couche électrique 1300 en TiN et la couche sacrificielle 1200 en LiPON, tel qu'obtenu au point 3.2, est placé dans une chambre sous une pression de 1 Pa.

Une méthode de gravure au plasma est mise en oeuvre dans les mêmes conditions que celles décrites au point 1.2.

Ainsi, les parties de la couche sacrificielle 1200 en LiPON non recouvertes par le masque dur et la couche d'arrêt sont éliminées par la gravure tandis que les parties protégées par le masque dur et la couche d'arrêt n'ont pas été attaquées par le plasma et donc n'ont pas été éliminées par la gravure.

Une structure telle que représentée sur la figure 10 est obtenue. Elle comprend le substrat 1100 dont sa surface est recouverte par la première couche électrique 1300 en TiN et dont la surface de cette couche électrique 1300 est recouverte localement, de façon sélective, par la couche sacrificielle 1200 en LiPON.

### 3.4- Croissance de la couche fonctionnelle diélectrique en HfOz (couche électriquement isolante) :

Tout en restant sous vide, l'ensemble formé par le substrat 1100, la première couche électrique 1300 en TiN et la couche sacrificielle 1200 en LiPON, tel qu'obtenu au point 3.3 ci-avant, est déplacé vers une chambre ALD, dédiée aux dépôts de couches diélectriques.

Un dépôt par ALD est mis en oeuvre dans les mêmes conditions que celles décrites au point 2.4.

Ainsi, la couche fonctionnelle diélectrique 1400 en HfO₂ d'une épaisseur de 10 nm, est déposée sur les parties de la surface de la première couche électrique 1300 en TiN dépourvues de la couche sacrificielle 1200 en LiPON.

### 3.5- Croissance de la couche fonctionnelle électrique en TiN (deuxième électrode) :

Tout en restant sous vide, l'ensemble formé par le substrat 1100, la première couche électrique 1300 en TiN, la couche sacrificielle 1200 en LiPON et la couche fonctionnelle diélectrique 1400 en HfOz, tel qu'obtenu au point 3.4 ci-avant, est déplacé vers une chambre ALD, dédiée aux dépôts de couches électriques.

Un dépôt par ALD est mis en oeuvre dans les mêmes conditions que celles décrites au point 3.1.

Ainsi, la couche fonctionnelle électrique 1500 en TiN, d'une épaisseur de 10 nm, est déposée sur la surface de la couche fonctionnelle diélectrique 1400. Elle n'est pas déposée sur la couche sacrificielle.

La structure obtenue est représentée sur la figure 11.

### 3.6- Élimination de la couche sacrificielle en LiPON :

L'ensemble obtenu au point 3.5 ci-avant est placé dans une chambre sous une pression de 1 Pa.

Une méthode de gravure au plasma, avec un plasma fluoré à base de CHF₃, est mise en oeuvre pendant 10 secondes, éliminant ainsi la totalité de la couche sacrificielle 1200 en LiPON.

Ainsi, une structure telle qu'illustrée sur la figure 12 est obtenue. Elle comprend le substrat 1100 dont sa surface est recouverte par la première couche électrique 1300 en TiN, la surface de cette couche électrique 1300 étant recouverte localement, de manière sélective, par un empilement de la couche fonctionnelle diélectrique 1400 et de la couche fonctionnelle électrique 1500.

Une capacitance de type MIM est ainsi obtenue par l'empilement de ces trois couches.

Dans cet exemple 3, le substrat présente une surface plane.

Cependant, les différentes étapes de l'exemple 3 pourraient être mises en oeuvre sur un substrat ayant une surface microstructurée.

## Revendications

1. Procédé de structuration d'une couche fonctionnelle (130 ; 230 ; 1400 ; 1500), comprenant au moins les étapes suivantes :
a) fourniture d'un substrat (110 ; 210 ; 1100) ayant une surface recouverte localement par une couche dite sacrificielle (120 ; 220 ; 1200) en un matériau lithié, une ou plusieurs zones de la surface du substrat (110 ; 210 ; 1100) étant dépourvues de la couche sacrificielle (120 ; 220 ; 1200) ;
b) croissance de la couche fonctionnelle (130; 230 ; 1400 ; 1500) de manière sélective sur la ou les zones de la surface du substrat (110 ; 210 ; 1100) dépourvues de la couche sacrificielle (120 ; 220 ; 1200), la couche fonctionnelle (130 ; 230 ; 1400 ; 1500) étant obtenue à partir d'un précurseur halogéné comprenant du chlore, de l'iode ou du brome, de préférence du chlore ;
c) élimination de la couche sacrificielle (120 ; 220 ; 1200) ; moyennant quoi la surface du substrat (110 ; 210 ; 1100) est recouverte par une couche fonctionnelle (130 ; 230 ; 1400 ; 1500) structurée.

2. Procédé de structuration selon la revendication 1, **caractérisé en ce que** l'étape a) comprend les sous-étapes suivantes :
i) dépôt de la couche sacrificielle (120 ; 220 ; 1200) sur tout ou partie de la surface du substrat (110 ; 210 ; 1100), de préférence par ALD ;
ii) élimination partielle de la couche sacrificielle (120 ; 220 ; 1200) en des endroits prédéterminés par gravure au plasma, gravure humide ou par gravure laser, préférence étant donnée à la gravure au plasma.

3. Procédé de structuration selon la revendication 1 ou la revendication 2, dans lequel la couche sacrificielle (120 ; 220 ; 1200) est en un oxyde de lithium ou un oxynitrure de lithium, par exemple choisi parmi LiPON, Li₂SiO₃, LiPO, LiSiPON, LiAlO₂, LiOH, Li₂O et Li₂CO₃, de préférence LiPON.

4. Procédé de structuration selon l'une quelconque des revendications 1 à 3, dans lequel l'étape b) s'effectue par ALD.

5. Procédé de structuration selon l'une quelconque des revendications 1 à 4, dans lequel la couche fonctionnelle (130 ; 230 ; 1500) est une couche électrique en un nitrure métallique tel que du nitrure de titane, du nitrure de tantale, du nitrure de molybdène ou du nitrure de tungstène, de préférence du nitrure de titane.

6. Procédé de structuration selon l'une quelconque des revendications 1 à 4, dans lequel la couche fonctionnelle (1400) est une couche diélectrique en un oxyde métallique choisi de préférence parmi l'oxyde d'hafnium, l'oxyde de silicium, l'oxyde de zirconium et l'oxyde de titane, de préférence l'oxyde d'hafnium.

7. Procédé de structuration selon l'une quelconque des revendications 1 à 6, dans lequel l'étape c) s'effectue par gravure au plasma, gravure humide ou par gravure laser, préférence étant donnée à la gravure au plasma, et encore plus préférentiellement à une gravure au plasma qui comprend du fluor, tel que du trifluorométhane, ou qui comprend du chlore, tel que du dichlore, préférence étant donnée au fluor.

8. Procédé de structuration selon l'une quelconque des revendications 1 à 7, dans lequel la surface du substrat (110; 210; 1100) est plane ou comprend une ou plusieurs zones planes et une ou plusieurs zones microstructurées.

9. Procédé de structuration selon l'une quelconque des revendications 1 à 7, dans lequel la surface du substrat (210) comprend une ou plusieurs zones planes et une ou plusieurs zones microstructurées formées, par exemple de pores ou de vias, la surface du substrat (210) étant recouverte par la couche sacrificielle (220) uniquement sur sa ou ses zones planes tandis que la ou les zones microstructurées sont dépourvues de la couche sacrificielle (220).

10. Procédé de préparation d'une capacitance de type Métal-Isolant-Métal qui comprend au moins les étapes suivantes :
- structuration d'une couche fonctionnelle électrique (130 ; 230 ; 1500) en mettant en oeuvre le procédé tel que défini dans les revendications 1 à 5 et 7 à 9 ;
- dépôt d'une couche diélectrique (240) ;
- dépôt d'une autre couche électrique (250), identique ou différente de la première couche fonctionnelle électrique (130 ; 230 ; 1500), de préférence identique.

11. Procédé de préparation d'une capacitance de type Métal-Isolant-Métal qui comprend au moins les étapes suivantes :
- structuration d'une couche fonctionnelle diélectrique (1400) en mettant en oeuvre le procédé tel que défini dans les revendications 1 à 4 et 6 à 9, le substrat (110 ; 210; 1100) fourni à l'étape a) comprenant un substrat support et une première couche électrique (1300), la première couche électrique (1300) étant recouverte localement par la couche sacrificielle (120 ; 220 ; 1200),
- dépôt d'une deuxième couche électrique sur la couche fonctionnelle diélectrique (1400), la deuxième couche électrique étant identique ou différente de la première couche électrique (1300), de préférence identique.

12. Procédé de préparation d'une capacitance de type Métal-Isolant-Métal qui comprend au moins une étape correspondant à la structuration d'une couche fonctionnelle électrique (130 ; 230 ; 1500) en mettant en oeuvre le procédé tel que défini dans les revendications 1 à 5 et 7 à 9, le substrat (110 ; 210 ; 1100) fourni à l'étape a) comprenant un substrat support, une première couche électrique (1300) et une couche diélectrique (240), la première couche électrique (1300) étant identique ou différente de la couche fonctionnelle électrique (130 ; 230 ; 1500), de préférence identique et la couche diélectrique (240) étant recouverte localement par la couche sacrificielle (120 ; 220 ; 1200).
